# EUROPEAN PATENT SPECIFICATION

(11) **EP 4 326 014 B1**
(45) Date of publication and mention of the grant of the patent: **27.05.2026**
(21) Application number: 23727192.9
(22) Date of filing: 25.04.2023
(51) Int. Cl.: H05K 1/11, H05K 1/18, H05K 3/36, H04M 1/02, H05K 1/09, H05K 3/34, H05K 1/14, H05K 1/02

(54) **CIRCUIT BOARD AND ELECTRONIC DEVICE COMPRISING SAME**
LEITERPLATTE UND ELEKTRONISCHE VORRICHTUNG DAMIT
CARTE DE CIRCUIT IMPRIMÉ ET DISPOSITIF ÉLECTRONIQUE LA COMPRENANT

(30) Priority: 27.06.2022 KR 20220078120; 08.08.2022 KR 20220098610
(43) Date of publication of application: 21.02.2024
(73) Proprietor: Samsung Electronics Co., Ltd., Suwon-si, Gyeonggi-do 16677 (KR)
(72) Inventor: KIM, Juntae, Suwon-si, Yeongtong-gu 16677 (KR); KIM, Younghoon, Suwon-si, Yeongtong-gu 16677 (KR); JANG, Jisang, Suwon-si, Yeongtong-gu 16677 (KR)
(74) Representative: Arnold & Siedsma
(86) International application number: PCT/KR2023/005604
(87) International publication number: WO 2024/005331

(56) References cited:
- CN-A- 113 474 879
- JP-A- 2018 093 011
- US-A1- 2020 373 285
- US-A1- 2020 373 285
- US-A1- 2021 408 015
- US-A1- 2022 007 512
- US-A1- 2022 199 595

## Description

### [Technical Field]

Various embodiments disclosed herein relate to an electronic device, for example, a circuit board and an electronic device including the same.

### [Background Art]

Thanks to the remarkable development of information communication technology, semiconductor technology, and the like, the distribution and use of various electronic devices are rapidly increasing. Particularly, recent electronic devices have been developed to be carried and used for communication.

The electronic devices may mean devices that perform a specific function according to a program provided therein (e.g., an electronic scheduler, a portable multimedia reproducer, a mobile communication terminal, a tablet PC, an image/sound device, a desktop/laptop PC, or a vehicle navigation system), as well as home appliances. For example, these electronic devices may output information stored therein as sound or image. With the increase of degree of integration of electronic devices and the generalization of ultra-high-speed and high-capacity wireless communication, a single electronic device, such as a mobile communication terminal, may be provided with various functions. For example, various functions, such as an entertainment function (e.g., a game function), a multimedia function (e.g., a music/video playback function), a communication and security function (e.g., a mobile banking function), a schedule management function, and an e-wallet function, are integrated in a single electronic device, in addition to a communication function. Such electronic devices have been downsized to be conveniently carried by a user.

Recently, due to the downsizing and thinning of portable electronic devices such as smartphones and the demand for high integration and high performance, such as the application of the latest antenna-related techniques, spaces for arranging printed circuit boards inside electronic devices have decreased. However, the spaces occupied by components tend to increase due to the addition of various functions.

US 2020/373285 A1 discloses integrated circuit device carriers and packaging assemblies which have attached decoupling capacitance. In one example, an assembly includes a package assembly coupled to a motherboard and comprising a carrier circuit board and an integrated circuit device coupled to a first side of the carrier circuit board. The assembly also includes decoupling capacitors for the integrated circuit device conductively coupled between the motherboard and a second side of the carrier circuit board opposite from at least a portion of a footprint of the integrated circuit device on the carrier circuit board.

CN 113 474 879 A discloses a substrate including a first substrate portion and a second substrate portion arranged opposite to the first substrate portion, and a capacitor component arranged between the first substrate portion and the second substrate portion. The capacitor component is attached to at least one of the first substrate portion and the second substrate portion. The capacitor component includes a dielectric, a first electrode on one side of the dielectric, and a second electrode through the dielectric on a side opposite to the first electrode. The first substrate portion and the second substrate portion are electrically connected to each other through the first electrode.

### [Detailed Description of the Invention]

### [Technical Solution]

The technical solution is provided by the appended claims.

According to an embodiment of the disclosure, an electronic device may include a housing, a first printed circuit board, a second printed circuit board, an interposer, a first electrical component, a power management integrated circuit, PMIC, and a capacitor. The first printed circuit board may be disposed in the housing. The second printed circuit board may be disposed in the housing. The second printed circuit board may be spaced apart from the first printed circuit board. The interposer may be disposed along at least a portion of an edge of the first printed circuit board or at least a portion of an edge of the second printed circuit board. The interposer may be configured to support the first printed circuit board and the second printed circuit board. The interposer may be configured to transmit an electrical signal of at least one electrical component mounted on the first printed circuit board or the second printed circuit board. The first electrical component may be disposed on the first printed circuit board. The PMIC may be disposed on the second printed circuit board. The capacitor may be coupled to the first printed circuit board and the second printed circuit board. The capacitor may be disposed adjacent to the PMIC. The capacitor may be configured to supply power that is supplied from the PMIC, to the first electrical component. The capacitor may include at least two electrodes disposed to be spaced apart from and in parallel to each other.

According to an embodiment of the disclosure, an electronic device may include a housing, a battery, and a circuit board. The battery may be disposed in the housing. The circuit board may be disposed adjacent to the battery in the housing. The circuit board may include a first printed circuit board, a second printed circuit board, an interposer, a first electrical component, a power management integrated circuit, PMIC, and a capacitor. The second printed circuit board may be spaced apart from the first printed circuit board. The interposer may be disposed along at least a portion of an edge of the first printed circuit board or at least a portion of an edge of the second printed circuit board. The interposer may be configured to support the first printed circuit board and the second printed circuit board. The interposer may be configured to transmit an electrical signal of at least one electrical component mounted on the first printed circuit board or the second printed circuit board. The first electrical component may be disposed on the first printed circuit board. The PMIC may be disposed on the second printed circuit board. The PMIC may be configured to supply power that is supplied from the battery, to the first electrical component. The capacitor may connect the first printed circuit board and the second printed circuit board. The capacitor may be disposed adjacent to the PMIC. The capacitor may be configured to supply power that is supplied from the PMIC, to the first electrical component.

According to an embodiment of the disclosure, a circuit board may include a first printed circuit board, a second printed circuit board, an interposer, a first electrical component, a power management integrated circuit, PMIC, and a power transmission member. The second printed circuit board may be spaced apart from the first printed circuit board. The interposer may be disposed along at least a portion of an edge of the first printed circuit board or at least a portion of an edge of the second printed circuit board. The interposer may be configured to support the first printed circuit board and the second printed circuit board. The interposer may be configured to transmit an electrical signal of at least one electrical component mounted on the first printed circuit board or the second printed circuit board. The first electrical component may be disposed on the first printed circuit board. The PMIC may be disposed on the second printed circuit board. The power transmission member may connect the first printed circuit board and the second printed circuit board. The power transmission member may be disposed adjacent to the PMIC. The power transmission member may be configured to supply power that is supplied from the PMIC, to the first electrical component.

### [Brief Description of Drawings]

FIG. 1 is a block diagram of an electronic device according to various embodiments in a network environment.
FIG. 2 is a front perspective view illustrating an electronic device according to an embodiment of the disclosure.
FIG. 3 is a rear perspective view illustrating the electronic device according to an embodiment of the disclosure.
FIG. 4 is an exploded perspective view of the electronic device according to an embodiment of the disclosure.
FIG. 5A is a front view of a first printed circuit board according to an embodiment of the disclosure.
FIG. 5B is a front view of a second printed circuit board according to an embodiment of the disclosure.
FIG. 5C is a front view illustrating a state in which the first printed circuit board and the second printed circuit board according to an embodiment of the disclosure are coupled.
FIG. 6 is a cross-sectional view of a circuit board according to an embodiment of the disclosure in a coupled state.
FIG. 7A is a cross-sectional view of the first printed circuit board according to an embodiment of the disclosure.
FIG. 7B is a cross-sectional view of the second printed circuit board according to an embodiment of the disclosure.
FIG. 8 is an enlarged view of area B in FIG. 6 according to an embodiment of the disclosure.
FIG. 9 is a cross-sectional view illustrating a circuit board and a plurality of electrical components according to an embodiment of the disclosure.
FIG. 10 is a cross-sectional view illustrating a circuit board according to an embodiment of the disclosure in a coupled state.
FIG. 11 is a cross-sectional view illustrating a circuit board according to an embodiment of the disclosure in a coupled state.

### [Mode for Carrying out the Invention]

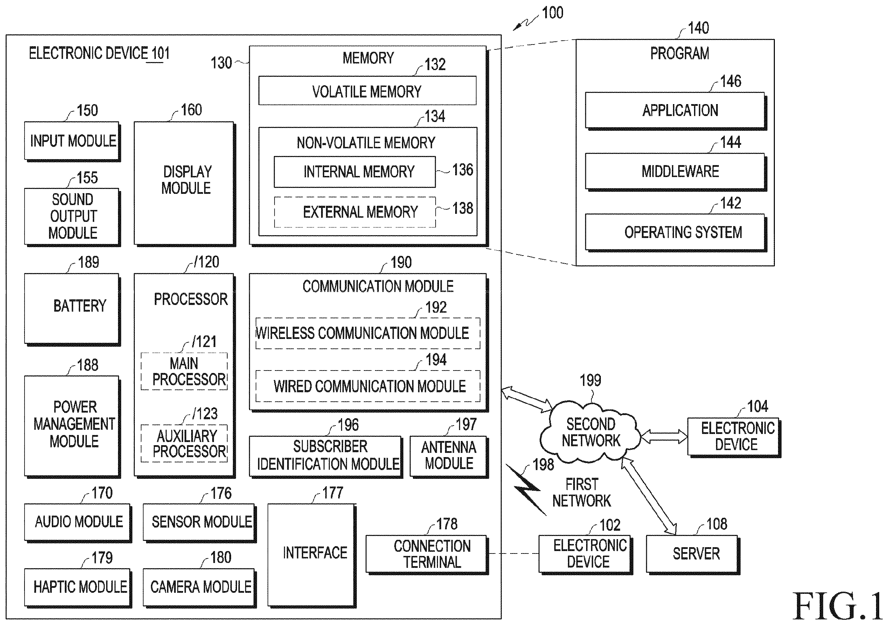

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control, for example, at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active (e.g., executing an application) state. According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence model is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or an external electronic device (e.g., an electronic device 102 (e.g., a speaker or a headphone)) directly or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199. using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C", may include any one of, or all possible combinations of the items enumerated together in a corresponding one of the phrases. As used herein, such terms as "1st" and "2nd", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", ***"coupled to"*, *"connected with"*,** or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic", "logic block", "part", or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semipermanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components or operations may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

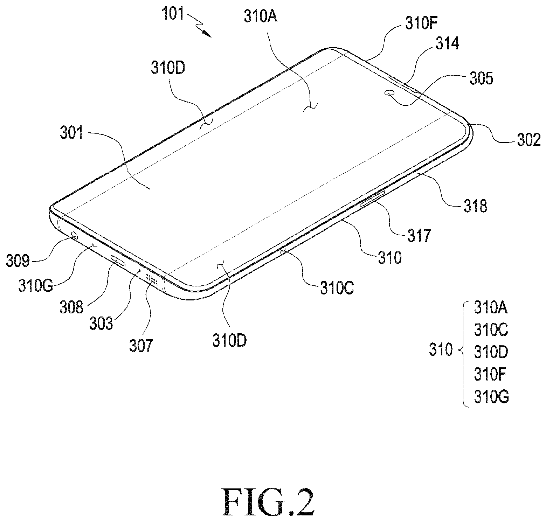

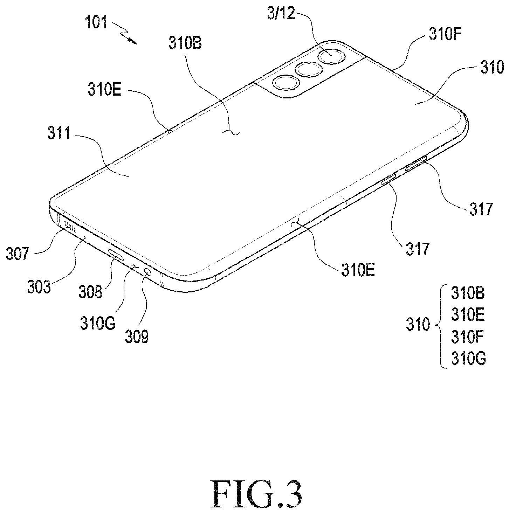

FIG. 2 is a front perspective view illustrating an electronic device according to an embodiment of the disclosure. FIG. 3 is a rear perspective view illustrating the electronic device according to an embodiment of the disclosure.

Referring to FIGS. 2 and 3, according to an embodiment, an electronic device 101 (e.g., the electronic device 101 in FIG. 1) may include a housing 310 including a front surface 310A, a rear surface 310B, and a side surface 310C surrounding the space between the front surface 310A and the rear surface 310B. In an embodiment (not illustrated), the housing 310 may refer to a structure that configures some of the front surface 310A and the side surface 310C in FIG. 2, and the side surface 310B in FIG. 3.

According to an embodiment, at least a portion of the front surface 310A of the housing 310 may be configured with a substantially transparent front surface plate 302 (e.g., a glass plate or a polymer plate including various coating layers). The rear surface 310B of the housing 310 may be configured with a rear surface plate 311. The side surface 310C of the housing 310 may be configured with a side surface bezel structure (or a "side surface member") 318 coupled to the front surface plate 302 and the rear surface plate 311 and including metal and/or polymer. In an embodiment, the rear surface plate 311 and the side surface bezel structure 318 may be integrally configured with each other, and may include the same material (e.g., glass, a metal material such as aluminum, or ceramic).

In the illustrated embodiment, the front surface plate 302 may include two first edge regions 310D, which are arranged at opposite ends of the longer edges of the front surface plate 302, respectively, and are curved and seamlessly extend from the front surface 310A toward the rear surface plate 311. In the illustrated embodiment (see FIG. 3), the rear surface plate 311 may include two second edge regions 310E formed at opposite ends of the longer edges thereof, respectively, and curved and seamlessly extending from the rear surface 310B toward the front surface plate 302. In an embodiment, the front surface plate 302 (or the rear surface plate 311) may include only one of the first edge areas 310D (or the second edge areas 310E). In an embodiment, some of the first edge areas 310D or the second edge areas 310E may not be included. In the above-described embodiments, when viewed from a side of the electronic device 101, the side surface bezel structure 318 may have a first thickness (or width) on the side surface portions that do not include the first edge areas 310D or the second edge areas 310E, and may have a second thickness, which is smaller than the first thickness, on the side surface portions that include the first edge areas 310D or the second edge areas 310E.

According to an embodiment, the display 301 (e.g., the display module 160 in FIG. 1) may be visually exposed, for example, through a substantial portion of the front surface plate 302. In an embodiment, at least a portion of the display 301 may be exposed through the front surface plate 302 configuring the front surface 310A and the first edge areas 310D. In an embodiment, the edges of the display 301 may be configured to be substantially the same as the shape of the periphery of the front surface plate 302 adjacent thereto. In an embodiment (not illustrated), the distance between the periphery of the display 301 and the periphery of the front surface plate 302 may be substantially constant in order to enlarge the exposed area of the display 301.

According to an embodiment, the surface of the housing 310 (or the front surface plate 302) may include a screen display area provided since the display 301 is visually exposed. As an example, the screen display area may include the front surface 310A and the first edge areas 310D.

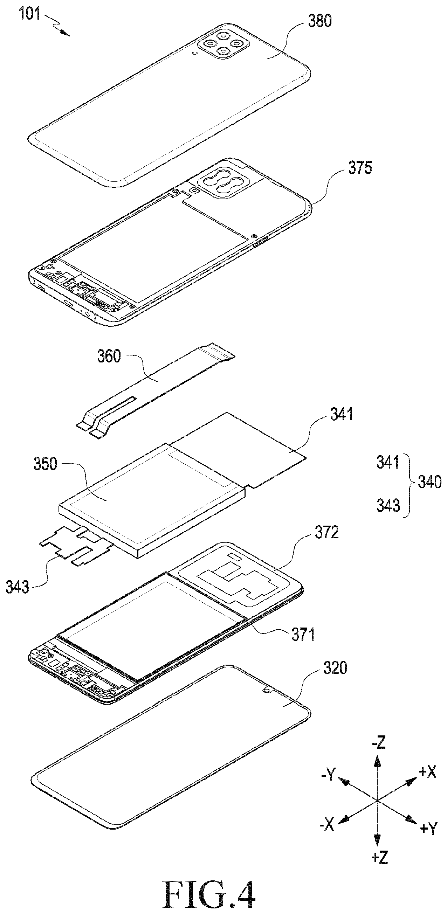

According to an embodiment, a first side surface 310F may be disposed in one direction (e.g., the +X direction in FIG. 4) of the housing 310, and a second side surface 310G may be disposed in the other direction (e.g., the -X direction in FIG. 4) of the housing 310.

In an embodiment (not illustrated), a recess or an opening may be provided in a portion of the screen display area (e.g., the front surface 310A and the first edge areas 310D) of the display 301, and at least one of an audio module 314 (e.g., the audio module 170 in FIG. 1), a sensor module (not illustrated) (e.g., the sensor module 176 in FIG. 1), a light-emitting element (not illustrated), and a camera module 305 (e.g., the camera module 180 in FIG. 1) may be aligned with the recess or the opening. In an embodiment (not illustrated), the display 301 may be coupled to or disposed adjacent to a touch-sensitive circuit, a pressure sensor capable of measuring a touch intensity (pressure), and/or a digitizer configured to detect an electromagnetic field-type stylus pen. In an embodiment, at least some of key input devices 317 may be disposed in the first edge areas 310D and/or the second edge areas 310E.

According to an embodiment, among the camera modules 305 and 312 (e.g., the camera module 180 in FIG. 1), a first camera module 305 and/or a sensor module may be disposed in the inner space of the electronic device to be in contact with the outer environment through the transmission area of the display 301. According to an embodiment, the area of the display 301 that faces the first camera module 305 may be configured as the transmission area having a predetermined transmittance, as a portion of a content display area. According to an embodiment, the transmission area may have a transmittance in the range of about 5% to about 20%. The transmission area may include an area overlapping an effective area (e.g., a field of view area) of the first camera module 305 through which light imaged by an image sensor to generate an image passes. For example, the transmission area of the display 301 may include an area having a lower pixel density and/or a lower wiring density than the surrounding area. For example, the transmission area may replace the recess or the opening.

According to an embodiment, the audio modules 303, 307, and 314 (e.g., the audio module 170 in FIG. 1) may include, for example, a microphone hole 303 and speaker holes 307 and 314. The microphone hole 303 may include a microphone disposed therein so as to acquire external sound, and in an embodiment, multiple microphones may be disposed therein to be able to detect the direction of sound. The speaker holes 307 and 314 may include an external speaker hole 307 and a call receiver hole 314. In an embodiment, while implementing the speaker holes 307 and 314 and the microphone hole 303 as a single hole, or a speaker (e.g., a piezo speaker) may be included without the speaker holes 307 and 314. The audio module 303, 307, or 314 is not limited to the above-described structure, and may be variously changed in design depending on the structure of the electronic device 101 by mounting only some audio modules or by adding new audio modules.

According to an embodiment, sensor modules (not illustrated) may generate an electrical signal or a data value corresponding to, for example, an internal operating state of the electronic device 101 or an external environmental state. The sensor modules (not illustrated) may include, for example, a first sensor module (e.g., a proximity sensor) and/or a second sensor module (e.g., a fingerprint sensor) disposed on the front surface 310A of the housing 310, and/or a third sensor module (e.g., an HRM sensor) and/or a fourth sensor module (e.g., a fingerprint sensor) disposed on the rear surface 310B of the housing 310. In some embodiments (not illustrated), the fingerprint sensor may be disposed not only on the front surface 310A (e.g., the display 301) of the housing 310, but also on the rear surface 310B. The electronic device 101 may further include at least one of sensor modules (not illustrated), such as a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor. The sensor modules are not limited to the above-described structure, and may be variously changed in design depending on the structure of the electronic device 101, for example, by mounting only some of the sensor modules or by adding new sensor modules.

According to an embodiment, the camera modules 305 and 312 may include, for example, a first camera module 305 disposed on the front surface 310A of the electronic device 101, a second camera module 312 disposed on the rear surface 310B, and/or a flash (not illustrated). The camera modules 305 and 312 may include one or more lenses, an image sensor, and/or an image signal processor. The flash (not illustrated) may include, for example, a light-emitting diode or a xenon lamp. In some embodiments, two or more lenses (e.g., an infrared camera lens, a wide-angle lens, and a telephoto lens) and image sensors may be disposed on one surface of the electronic device 101. The camera modules 305 and 312 are not limited to the above-described structure, and may be variously changed in design depending on the structure of the electronic device 101, for example, by mounting only some of the camera modules or by adding new modules.

According to an embodiment, the electronic device 101 may include a plurality of camera modules (e.g., a dual camera or a triple camera) having different properties (e.g., fields of view) or functions, respectively. For example, a plurality of camera modules 305 and 312 including lenses having different fields of view may be configured, and the electronic device 101 may control the change of the fields of view of the camera modules 305 and 312 executed therein based on a user's selection. For example, at least one of the camera modules 305 and 312 may be a wide-angle camera, and at least one of other camera modules may be a telephoto camera. Similarly, at least one of the camera modules 305 and 312 may be a front camera, and at least one of other camera modules may be a rear camera. In addition, the camera modules 305 and 312 may include at least one of a wide-angle camera, a telephoto camera, or an infrared (IR) camera (e.g., a time-of-flight (TOF) camera, or a structured light camera). According to an embodiment, the IR camera may be operated as at least a part of a sensor module. For example, the TOF camera may be operated as at least a part of a sensor module (not illustrated) for detecting a distance to a subject.

According to an embodiment, the key input devices 317 may be disposed on the side surface 310C of the housing 310. In an embodiment, the electronic device 101 may not include some or all of the above-mentioned key input devices 317, and a key input device 317, which is not included, may be implemented in another form, such as a soft key, on the display 301. In an embodiment, the key input devices may include a sensor module disposed on the rear surface 310B of the housing 310.

According to an embodiment, the light-emitting element (not illustrated) may be disposed on, for example, the front surface 310A of the housing 310. The light-emitting element (not illustrated) may provide, for example, the state information of the electronic device 101 in an optical form. In an embodiment, the light-emitting device (not illustrated) may provide, for example, a light source interlocked with the operation of the first camera module 305. The light-emitting device (not illustrated) may include, for example, an LED, an IR LED, and/or a xenon lamp.

According to an embodiment, the connector holes 308 and 309 may include, for example, a first connector hole 308 capable of accommodating a connector (e.g., USB connector) configured to transmit/receive power and/or data to/from an external electronic device (not illustrated) (e.g., the external electronic device 102 in FIG. 1) and/or a second connector hole 309 capable of accommodating a connector (e.g., an earphone jack) configured to transmit/receive an audio signal to/from an external electronic device.

According to an embodiment, the first camera module 305 and/or some of the sensor modules (not illustrated) may be disposed to be exposed to the outside through at least a portion of the display 301. For example, the first camera module 305 may include a punch hole camera disposed inside a hole or recess provided in the rear surface of the display 301 (e.g., a surface facing the inside of the electronic device 101). According to an embodiment, the second camera module 312 may be disposed inside the housing 310 such that the lens is exposed to the rear surface 310B of the electronic device 101. For example, the second camera module 312 may be disposed on a printed circuit board (not illustrated) (e.g., the printed circuit board 340 in FIG. 4).

According to an embodiment, the first camera module 305 and/or the sensor modules may be disposed from the inner space of the electronic device 101 to the front surface plate 302 of the display 301 to come into contact with the outer environment through a transparent area. In addition, some sensor modules may be disposed in the inner space of the electronic device to perform the functions thereof without being visually exposed through the front surface plate 302.

FIG. 4 is an exploded perspective view of the electronic device according to an embodiment of the disclosure.

Hereinafter, for convenience of description, the direction from the rear surface plate 380 toward the front surface plate 320 may be defined and/or interpreted as the +Z direction, and the direction from the front surface plate 320 toward the rear surface plate 380 may be defined and/or interpreted as the -Z direction. The direction from the second circuit board 343 toward the first circuit board 341 may be defined and/or interpreted as the +X direction, and the direction from the first circuit board 341 toward the second circuit board 343 may be defined and/or interpreted as the -X direction. In addition, one of the directions perpendicular to the plane defined by the X axis and the Z axis with reference to the battery 350 may be defined and/or interpreted as the +Y direction, and the other one of the directions perpendicular to the plane defined by the X axis and the Z axis with reference to the battery 350 may be defined and/or interpreted as the -Y direction. For example, the X-axis direction may be defined and/or interpreted as the length direction of the electronic device 101 and the components of the electronic device 101, the Y-axis direction may be defined and/or interpreted as the width direction of the electronic device 101 and the components of the electronic device 101, and the Z-axis direction may be defined and/or interpreted as the height direction and/or the thickness direction of the electronic device 101 and the components of the electronic device 101.

The configuration of the front surface plate 320 and/or the rear surface plate 380 of FIG. 4 may be wholly or partly the same as the configuration of the front surface plate 302 and/or the rear surface plate 311 of FIGS. 2 to 3.

Referring to FIG. 4, an electronic device 101 (e.g., the electronic device 101 in FIG. 1) according to an embodiment may include a first support member 372, a front surface plate 320 (e.g., the front surface plate 302 in FIG. 2), a circuit board 340, a battery 350 (e.g., the battery 189 in FIG. 1), a flexible circuit board 360, a second support member 375 (e.g., the rear case), and/or a rear surface plate 380 (e.g., the rear surface plate 311 in FIG. 3). According to an embodiment, the first support member 372 of the electronic device 101 may include a side surface bezel structure 371 (e.g., the side surface bezel structure 318 in FIG. 2).

According to an embodiment, in the electronic device 101, any one of the above-described components (e.g., the first support member 372 or the second support member 375) may be omitted, or other components may be additionally included. At least one of the components of the electronic device 101 may be the same as or similar to at least one of the components of the electronic device 101 in FIGS. 1 to 3, and a redundant description thereof may be omitted below.

According to an embodiment, the first support member 372 may be disposed inside the electronic device 101 and connected to the side surface bezel structure 371 (e.g., the side surface bezel structure 318 in FIG. 2) or may be configured integrally with the side surface bezel structure 371. The first support member 372 may be made of, for example, a metal material and/or a non-metal (e.g., a polymer) material. According to an embodiment, a display (not illustrated) (e.g., the display 301 in FIG. 2) may be coupled to one surface of the first support member 372, and at least a portion of the circuit board 340 may be coupled to the other surface.

According to an embodiment, the circuit board 340 (e.g., a printed circuit board (PCB), a flexible PCB (FPCB), or a rigid flexible PCB (RFPCB)) may be mounted with a processor (not illustrated) (e.g., the processor 120 in FIG. 1), memory (not illustrated) (e.g., the memory 130 in FIG. 1), and/or interface (not illustrated) (e.g., the interface 177 in FIG. 1) or may be electrically connected to the above-mentioned components. The processor may include at least one of, for example, a central processing unit, an application processor, a graphics processing unit, an image signal processor, a sensor hub processor, or a communication processor. According to an embodiment, the circuit board 340 may include a flexible printed circuit board-type radio frequency cable (FRC). For example, at least a portion of the circuit board 340 may be disposed on the first support member 372, and may be electrically connected to an antenna module (not illustrated) (e.g., the antenna module 197 in FIG. 1) and/or a communication module (not illustrated) (e.g., the communication module 190 in FIG. 1). According to an embodiment, the circuit board 340 may include a first circuit board 341 and/or a second circuit board 343. According to an embodiment (not illustrated), the circuit board 340 may not include the second circuit board 343 or may include an additional circuit board (not illustrated). According to an embodiment, the first circuit board 341 and/or the second circuit board 343 may be disposed in a housing (e.g., the housing 310 in FIGS. 2 and 3).

According to an embodiment, the first circuit board 341 may be a structure in which a pair of printed circuit boards (PCBs) are stacked and coupled via an interposer. According to an embodiment, the first circuit board 341 may be defined and interpreted as a main board or main circuit board. According to an embodiment, the second circuit board 343 may be defined and interpreted as a sub-board or sub-circuit board.

According to an embodiment, the memory may include volatile memory (not illustrated) (e.g., the volatile memory 132 in FIG. 1) or non-volatile memory (not illustrated) (e.g., the non-volatile memory 134 in FIG. 1).

According to an embodiment, the interface may include a high-definition multimedia interface (HDMI), a universal serial bus (USB) interface, an SD card interface, and/or an audio interface. For example, the interface may electrically and/or physically connect the electronic device 101 to an external electronic device (e.g., the external electronic device 102 in FIG. 1), and may include a USB connector, an SD card/MMC connector, and/or or an audio connector.

According to an embodiment, the battery 350 is a device for supplying power to at least one component or electrical component of the electronic device 101, and may include a nonrechargeable primary battery, a rechargeable secondary battery, or a fuel cell. According to an embodiment, the battery 350 may be integrally disposed inside the electronic device 101. According to an embodiment, the battery 350 may be detachably disposed on the electronic device 101.

According to an embodiment, the second support member 375 (e.g., the rear case) may be disposed between the circuit board 340 and an antenna (not illustrated) (e.g., the antenna module 197 in FIG. 1). According to an embodiment, the second support member 375 may include one surface to which the printed circuit board 340 and/or the battery 350 are coupled and the other surface to which the antenna is coupled.

According to an embodiment, the antenna may be disposed between the rear surface plate 380 and the battery 350. For example, the antenna may include a near-field communication (NFC) antenna, a wireless charging antenna, and/or a magnetic secure transmission (MST) antenna. For example, the antenna may perform short-range communication with an external device or wirelessly transmit/receive power required for charging to/from an external device. In an embodiment, the antenna structure may be configured by a portion of the side surface bezel structure 371 and/or the first support member 372 or a combination thereof.

According to an embodiment, the rear surface plate 380 may configure at least a portion of the rear surface of the electronic device 101 (e.g., the rear surface 310B in FIG. 3).

According to an embodiment, the electronic device 101 may include a flexible printed circuit board (FPCB) 360. According to an embodiment, the flexible printed circuit board 360 may electrically interconnect the first circuit board 341 and the second circuit board 343. According to an embodiment, the flexible circuit board 360 may electrically interconnect at least one of the first circuit board 341 or the second circuit board 343 and an electrical component (e.g., the audio module 307 or the connector holes 308 and 309 in FIG. 3).

According to an embodiment, the first circuit board 341 may include one surface facing the rear surface plate 380 (e.g., the surface facing the -Z direction in FIG. 4) and the other surface facing the front surface plate 320 (e.g., the surface facing the +Z direction in FIG. 4). According to an embodiment, the one surface of the first circuit board 341 may be mounted with a camera module (not illustrated) (e.g., the second camera module 312 in FIG. 3) or may be electrically connected to the camera module. According to an embodiment, the other surface of the first circuit board 342 may be mounted with a camera module (not illustrated) (e.g., the first camera module 305 in FIG. 2) or may be electrically connected to the camera module.

According to an embodiment, the first circuit board 342 may be mounted with at least one of multiple electrical components (not illustrated) (e.g., the processor 120, the memory 130, or the power management integrated circuit 180 in FIG. 1).

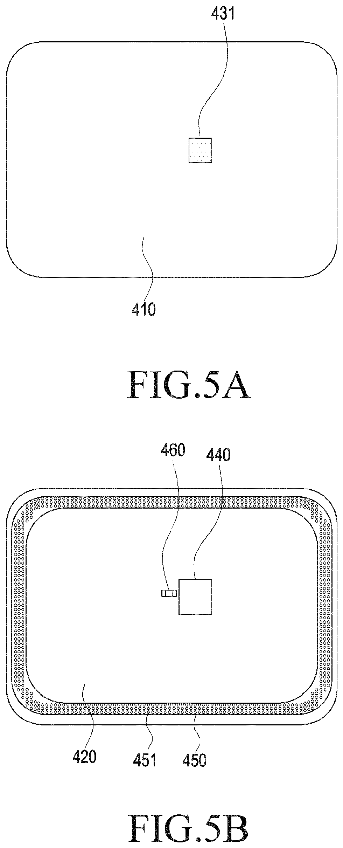

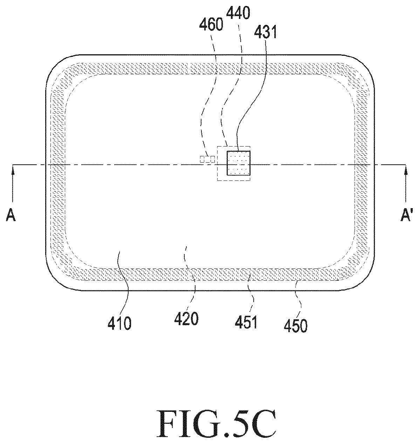

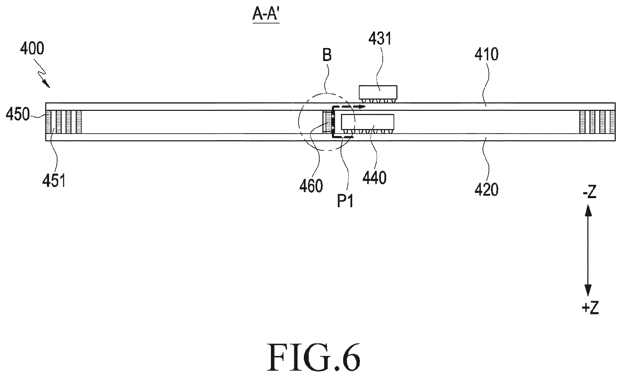

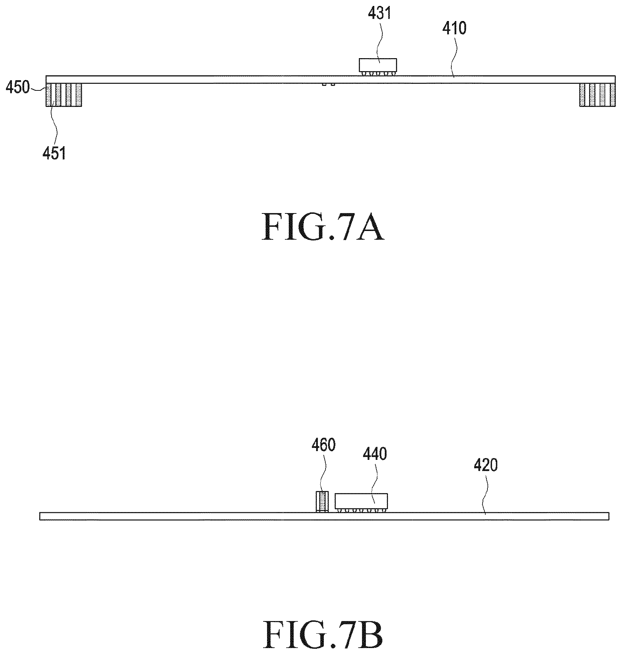

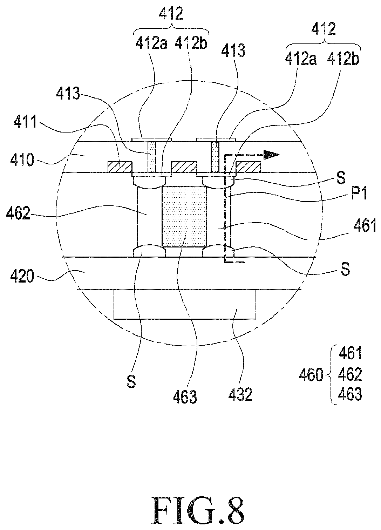

FIG. 5A is a front view of a first printed circuit board according to an embodiment of the disclosure. FIG. 5B is a front view of a second printed circuit board according to an embodiment of the disclosure. FIG. 5C is a front view illustrating a state in which the first printed circuit board and the second printed circuit board according to an embodiment of the disclosure are coupled. FIG. 6 is a cross-sectional view of a circuit board according to an embodiment of the disclosure in the coupled state. FIG. 7A is a cross-sectional view of the first printed circuit board according to an embodiment of the disclosure. FIG. 7A is a cross-sectional view taken along line A-A' of FIG. 5C according to an embodiment of the disclosure. FIG. 7B is a cross-sectional view of the second printed circuit board according to an embodiment of the disclosure. FIG. 8 is an enlarged view of area B in FIG. 6 according to an embodiment of the disclosure.

Referring to FIGS. 5A to 8, the circuit board 400 may include a first printed circuit board 410, a second printed circuit board 420, a first electrical component 431, a power management integrated circuit ,PMIC, 440, an interposer 450, and/or capacitor 460.

The configuration of the circuit board 400 of FIGS. 5A to 8 may be wholly or partly the same as that of the first circuit board 341 in FIG. 4.

According to an embodiment, the circuit board 400 may be disposed in a housing (e.g., the housing 310 in FIGS. 2 to 3) of an electronic device (e.g., the electronic device 101 in FIGS. 1 to 4).

According to an embodiment, the first printed circuit board (PCB) 410 may include one surface (e.g., the surface facing the -Z direction in FIG. 6) and the other surface facing the opposite direction to the one surface (e.g., the surface facing the +Z direction in FIG. 6). According to an embodiment, the one surface of the first printed circuit board 410 (e.g., the surface facing the -Z direction in FIG. 6) may be a surface facing a rear surface plate (e.g., the rear surface plate 380 in FIG. 4) inside the electronic device. According to an embodiment, the other surface of the first printed circuit board 410 (e.g., the surface facing the +Z direction in FIG. 6) may be a surface facing the second printed circuit board 420.

According to an embodiment, at least a portion of the first printed circuit board 410 may be electrically connected to a flexible printed circuit board (e.g., the flexible printed circuit board 360 in FIG. 4). According to an embodiment, the first printed circuit board 410 may be electrically connected to a sub-board (e.g., the second circuit board 343 in FIG. 4) via the flexible printed circuit board.

According to an embodiment, the second printed circuit board (PCB) 420 may include one surface (e.g., the surface facing the +Z direction in FIG. 6) and the other surface facing the opposite direction to the one surface (e.g., the surface facing the -Z direction in FIG. 6). According to an embodiment, the one surface of the second printed circuit board 420 (e.g., the surface facing the +Z direction in FIG. 6) may be a surface facing the front surface plate (e.g., the front surface plate 320 in FIG. 4) or the display (e.g., the display 301 in FIG. 2) inside the electronic device. According to an embodiment, the other surface of the second printed circuit board 420 may be a surface facing the first printed circuit board 410.

According to an embodiment, the first printed circuit board 410 and the second printed circuit board 420 may be disposed to be spaced apart from each other.

According to an embodiment, at least a portion of the second printed circuit board 420 may be disposed between the first printed circuit board 410 and the display (e.g., the display 301 in FIG. 2).

According to an embodiment, the interposer 450 may be disposed between the first printed circuit board 410 and the second printed circuit board 420. According to an embodiment, the interposer 450 may configure a side wall surrounding at least a portion between the first printed circuit board 410 and the second printed circuit board 420.

According to an embodiment, the interposer 450 may be disposed along at least a portion of an edge of the first printed circuit board 410 or at least a portion of an edge of the second printed circuit board 420. According to an embodiment, the interposer 450 may be configured to transmit electrical signals of electrical components mounted on the first printed circuit board 410 to the second printed circuit board 420 or electrical components mounted on the second printed circuit board 420. According to an embodiment, the interposer 450 may be configured to transmit electrical signals (e.g., data signals or power) of the electrical components mounted on the second printed circuit board 420 to the first printed circuit board 410 or the electrical components mounted on the first printed circuit board 410.

According to an embodiment, the interposer 450 may electrically interconnect the first printed circuit board 410 and the second printed circuit board 420. According to an embodiment, the interposer 450 may include a plurality of conductive vias 451 configuring conductive paths capable of transmitting data, power or signals between the first printed circuit board 410 and the second printed circuit board 420. The plurality of conductive vias 451 of the interposer 450 may be electrically connected to wires of the first printed circuit board 410 or wires of the second printed circuit board 420.

According to an embodiment, the circuit board 400 may be defined and referred to as an interposer board in which the first printed circuit board 410 and the second printed circuit board 420 are connected to each other via the interposer 450.

According to an embodiment, the interposer 450 may be disposed along the edge of the first printed circuit board 410 or the edge of the second printed circuit board 420. According to an embodiment, the interposer 450 may configure a side wall of the stacked structure of the first printed circuit board 410 and the second printed circuit board 420. According to an embodiment, a plurality of interposers 450 may be provided such that each of the interposers 450 electrically interconnect or support the first printed circuit board 410 and the second printed circuit board 420.

According to an embodiment, at least a portion of the PMIC 440 may be disposed between the capacitor 460 and the interposer 450. Referring to FIGS. 5A to 5C, at least a portion of the PMIC 440 may be disposed between the capacitor 460 and the interposer 450 with reference to the plane direction of the first printed circuit board 410 or the second printed circuit board 420 (e.g., the direction of the plane defined by the X axis and Y axis in FIG. 4).

According to an embodiment, the first electrical component 431 may be disposed on the first printed circuit board 410. According to an embodiment, the first electrical component 431 may be mounted on one surface of the first printed circuit board 410 (e.g., the surface facing the - Z direction in FIG. 6). According to an embodiment (not illustrated), the first electrical component 431 may be mounted on the other surface of the first printed circuit board 410 (e.g., the surface facing the +Z direction in FIG. 6). According to an embodiment, at least a portion of the first electrical component 431 may be soldered to the first printed circuit board 410.

According to an embodiment, at least a portion of the first electrical component 431 may face at least a portion of the PMIC 440 with the first printed circuit board 410 interposed therebetween.

According to an embodiment, the first electrical component 431 may be an electrical component that operates by using power supplied from the PMIC 440. According to an embodiment, the first electrical component 431 may be configured as an RFIC, a power amplifier module (PAM), or an application processor (AP), but, without being limited thereto, the first electrical component 431 may be configured as various electrical components operating by using the power supplied from the PMIC 440.

According to an embodiment, the power management integrated circuit, PMIC, 440 (e.g., the power management module 188 in FIG. 1) may be disposed on the second printed circuit board 420. According to an embodiment, the PMIC 440 may be mounted on the other surface of the second printed circuit board 440 (e.g., the surface facing the -Z direction in FIG. 6). According to an embodiment (not illustrated), the PMIC 440 may be mounted on one surface of the second printed circuit board 420 (e.g., the surface facing the +Z direction of FIG. 6). According to an embodiment, at least a portion of the PMIC 440 may be soldered to the second printed circuit board 420.

According to an embodiment, at least a portion of the PMIC 440 may be disposed between the capacitor 460 and the interposer 450.

According to an embodiment, the PMIC 440 may supply power that is supplied from a battery (e.g., the battery 189 of FIG. 1 or the battery 350 of FIG. 4), to an electrical component. For example, the PMIC 440 may supply power to an electrical component disposed or mounted on the second printed circuit board 420 via a wire of the second printed circuit board 420. In addition, the PMIC 440 may supply power to an electrical component disposed or mounted on the first printed circuit board 410 via a wire of the second printed circuit board 420 the interposer 450, and a wire of the first printed circuit board 440. In addition, the PMIC 440 may supply power to a first electrical component 431 disposed or mounted on the first printed circuit board 410 via a wiring of the second printed circuit board 420, the capacitor 460, and a wire of the first printed circuit board 410.

According to an embodiment, the PMIC 440 may be disposed between the first printed circuit board 410 and the second printed circuit board 420. According to an embodiment, the PMIC 440 may be disposed to be spaced apart from the interposer 450 while being surrounded by the interposer 450.

According to an embodiment, the capacitor 460 may electrically interconnect the first printed circuit board 410 and the second printed circuit board 420. According to an embodiment, the capacitor 460 may be a decoupling capacitor, but is not limited thereto.

According to an embodiment, at least a portion of the capacitor 460 may be electrically connected to the first printed circuit board 410, and a portion different from the at least a portion may be electrically connected to the second printed circuit board 420. According to an embodiment, the capacitor 460 may be disposed adjacent to the PMIC 440.

According to an embodiment, the capacitor 460 may configure a conductive path for power to be supplied from the PMIC 440 to the first electrical component 431. According to an embodiment, the capacitor 460 may operate as an output capacitor of the PMIC 440 and an input capacitor of the first electrical component 431. According to an embodiment, the capacitor 460 may be defined and referred to as a power transmission member.

According to an embodiment, the capacitor 460 may be coupled to the first printed circuit board 410 and the second printed circuit board 420. According to an embodiment, the capacitor 460 may be disposed adjacent to the first electrical component 431 mounted on the first printed circuit board 410. According to an embodiment, the capacitor 460 may be spaced apart from the interposer 450. According to an embodiment, capacitor 460 may be disposed adjacent to the PMIC 440.

According to an embodiment, by configuring the circuit board 400 such that the PMIC 440 and the first electrical component 431 share one capacitor 460, it is possible to reduce the number of required capacitors compared to the case where each of the PMIC 440 and the first electrical component 431 is provided with one capacitor.

According to an embodiment, the capacitor 460 may reduce a conductive path through which power is transmitted between the PMIC 440 and the first electrical component 431. Compared to the case where power supplied from the PMIC 440 is supplied to the first electrical component 431 via the interposer 450, the DCR of the conductive path provided through the capacitor 440 may be lowered.

According to an embodiment, since the power supplied from the PMIC 440 to the first electrical component 431 is transmitted via the capacitor 460, a plurality of pins of the interposer 450 may not be allocated to supply power to the first electrical component 431. Accordingly, since the number of pins of the interposer 450 is reduced or the pins are allocated for various electrical components, the degree of freedom in designing the circuit board 400 may be improved.

According to an embodiment, at least a portion of the first electrical component 431 may be disposed to overlap at least a portion of the PMIC 440 in a direction from the first printed circuit board 410 toward the second printed circuit board 420 (e.g., the +Z direction in FIG. 6) or a direction from the second printed circuit board 420 toward the first printed circuit board 410 (e.g., the -Z direction in FIG. 6).

According to an embodiment, the distance from the capacitor 460 to the PMIC 440 may be shorter than the distance from the capacitor 460 to the interposer 450. For example, the capacitor 460 may be placed closer to the PMIC 440 than the interposer 450.

Referring to FIGS. 6, 7A, and 7B, the circuit board 400 may be manufactured by coupling the first printed circuit board 410 and the second printed circuit board 420.

Referring to FIG. 7A, the first electrical component 431 and the interposer 450 may be disposed or mounted on the first printed circuit board 410.

Referring to FIG. 7B, the PMIC 440 and the capacitor 460 may be disposed or mounted on the second printed circuit board 420.

According to an embodiment, the second printed circuit board 420 may be coupled to the first printed circuit board 410 on which the interposer 450 is mounted through surface mount technology (SMT) to configure the circuit board 400. When the first printed circuit board 410 and the second printed circuit board 420 are connected to each other, the capacitor 460 disposed on the first printed circuit board 410 may be electrically connected to at least a portion of the first printed circuit board 410.

Referring to FIG. 8, the capacitor 460 may include a first portion 461, a second portion 462 and a third portion 463. According to an embodiment, the first portion 461 and the second portion 462 may include electrodes therein, respectively, and the third portion 463 may be a capacitor housing providing an empty space between the electrodes. According to an embodiment, the capacitor 460 may include at least two electrodes spaced apart from each other and disposed in parallel to each other. According to an embodiment, a first electrode among the at least two electrodes may be included in the first portion 461, and a second electrode among the at least two electrodes may be included in the second portion 462.

According to an embodiment, the capacitor 460 may be configured to remove a DC component of power supplied from the PMIC 440 to the first electrical component 431.

According to an embodiment, the first portion 461 and the second portion 462 may be electrically connected to the first printed circuit board 410 and the second printed circuit board 420, respectively. The first portion 461 may provide a conductive path P1 of power transmitted from the PMIC 440 to the first electrical component 431. At least a portion of the second printed circuit board 420 connected to the second portion 462 may provide a ground.

According to an embodiment, the first portion 461 and the second portion 462 of the capacitor 460 may be soldered (S) to the first printed circuit board 410 and the second printed circuit board 420.

According to an embodiment, the first printed circuit board 410 may include a non-metal area 411. According to an embodiment, the non-metal area of the first printed circuit board 410 may be provided on at least a portion of the first printed circuit board 410 and may be made by removing the metal area of the at least a portion.

According to an embodiment, the non-metal area of the first printed circuit board 410 may be disposed near a portion in which the first portion 461 and the second portion 462 of the capacitor 460 are coupled to or mounted on the first printed circuit board 410.

According to an embodiment, the non-metal area 411 may be disposed adjacent to the first portion 461 or the second portion 462 of the capacitor 460.

According to an embodiment, when preheating the first printed circuit board 410 to perform a soldering operation on the first printed circuit board 410, the non-metallic area 411 of the first printed circuit board 410 may have a lower temperature than other portions. Accordingly, portions disposed between a plurality of non-metal areas 411 of the first printed circuit board 410 may have a relatively higher temperature than the non-metal areas 411. Accordingly, when a soldering operation for soldering coupling the first printed circuit board 410 is performed, heat may be concentrated in the portions disposed between the non-metal areas 411.

According to an embodiment, the first printed circuit board 410 may further include copper foil layers 412. According to an embodiment, the copper foil layers 412 may include a first copper foil layer 412a disposed on one surface of the first printed circuit board 410 (e.g., the surface facing the -Z direction of FIG. 6) and a second copper foil layer 412b disposed on the other surface facing the opposite direction to the one surface (e.g., the side facing the +Z direction in FIG. 6). According to an embodiment, a pair of first copper foil layers 412a may be provided and connected to the first portion 461 and the second portion 462, respectively. According to an embodiment, a pair of second copper foil layers 412b may be provided and have positions corresponding to the pair of first copper foil layers 412a, respectively.

According to an embodiment, the first copper foil layer 412a and the second copper foil layer 412b may have positions corresponding to the first portion 461 and the second portion 462 of the capacitor 460, respectively.

According to an embodiment, when preheating the first printed circuit board 410 to perform a soldering operation on the first printed circuit board 410, the first copper foil layer 412a and the second copper foil layer 412b may have a higher temperature than other portions. Accordingly, the portions of the first printed circuit board 410 in which the first copper foil layer 412a and the second copper foil layer 412b are connected or disposed may have a relatively higher temperature than other portions. Accordingly, when performing a soldering operation for soldering coupling on the first printed circuit board 410, soldering may be concentrated on the second copper foil layer 412b.

Referring to FIG. 8, the circuit board 400 may further include a second electrical component 432. According to an embodiment, the second electrical component 432 may be disposed or mounted on one surface of the second printed circuit board 420 (e.g., the surface facing the +Z direction in FIG. 6). According to an embodiment, the second electrical component 432 may be a processor (e.g., the processor 120 of FIG. 1), but is not limited thereto. According to an embodiment, at least a portion of the second electrical component 432 may face the capacitor 460 with the second printed circuit board 420 interposed therebetween.

According to an embodiment, heat generated by the second electrical component 432 may be transferred to the first printed circuit board 410 via the second printed circuit board 420 and the capacitor 460, and the heat transferred to the first printed circuit board 410 may be transferred toward the surface of the first printed circuit board 410 or may be dissipated through a member connected to the first printed circuit board 410 (e.g., the rear case 375 or the rear surface plate 380 in FIG. 4). According to an embodiment, the first printed circuit board 410 may further include a pair of vias 413 provided at portions coupled to the first portion 461 and the second portion 462, respectively. According to an embodiment, the pair of vias 413 of the first printed circuit board 410 may provide a heat transfer path such that the heat transferred from the second electrical component 432 is more quickly transferred to the first printed circuit board 410.

According to an embodiment, the thickness of the interposer 450 (e.g., the thickness in the Z-axis direction of FIG. 6) may be about 0.9 mm (e.g., about 0.9T), but is not limited thereto. According to an embodiment, the separation distance between the first printed circuit board 410 and the second printed circuit board 420 may be about 0.9 mm (e.g., about 0.9T), but is not limited thereto. According to an embodiment, the thickness of the capacitor 460 (e.g., the thickness in the Z-axis direction of FIG. 6) may be about 0.8 mm (e.g., about 0.8T), but is not limited thereto. According to an embodiment, the circuit board 400 may be fabricated by appropriately adjusting the size of soldering or solder depending on the thickness of the capacitor 460.

According to an embodiment, the capacitor 460 may be replaced with a separate interposer different from the interposer 450. For example, a separate interposer may be disposed adjacent to the PMIC 440 and may be configured to transmit power that is supplied from the PMIC 440, to the first electrical component 431.

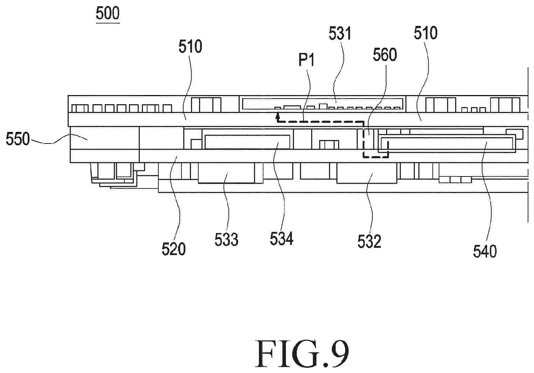

FIG. 9 is a cross-sectional view illustrating a circuit board and a plurality of electrical components according to an embodiment of the disclosure.

Referring to FIG. 9, a circuit board 500 (e.g., the circuit board 400 in FIGS. 6 to 8) may include a first printed circuit board 510, a second printed circuit board 520, a first electrical component 531, a second electrical component 532, a third electrical component 533, a fourth electrical component 534, a PMIC 540, an interposer 550, and a capacitor 560.

All or some of the configurations of the first printed circuit board 510 of FIG. 9, the second printed circuit board 520, the first electrical component 531, the second electrical component 532, the PMIC 540, the interposer 550, and the capacitor 560 may be the same as those of the first printed circuit board 410, the second printed circuit board 420, the first electrical component 431, the second electrical component 432, the PMIC 440, the interposer 450, and the capacitor 460 in FIGS. 6 to 8.

According to an embodiment, the capacitor 560 may provide at least a portion of a conductive path P1 of power supplied from the PMIC 540 to the first electrical component 531.

According to an embodiment, the third electrical component 533 may be memory (e.g., the memory 130 in FIG. 1), but is not limited thereto. The third electrical component 533 may be mounted on one surface of the second printed circuit board 520 (e.g., the surface facing the +Z direction in FIG. 6).

According to an embodiment, the fourth electrical component 534 may be an additional power management integrated circuit, PMIC (e.g., the power management module 188 in FIG. 1) separate from the PMIC 540, but is not limited thereto. According to an embodiment, at least a portion of the fourth electrical component 534 may face the third electrical component 533 with the second printed circuit board 520 interposed therebetween. According to an embodiment, the fourth electrical component 534 may be mounted on the other surface of the second printed circuit board 520 (e.g., the surface facing the -Z direction in FIG. 6).

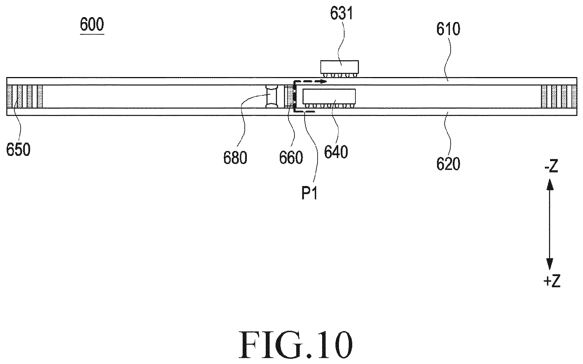

FIG. 10 is a cross-sectional view illustrating a circuit board according to an embodiment of the disclosure in a coupled state.

Referring to FIG. 10, a circuit board 600 (e.g., the circuit board 400 in FIGS. 6 to 8) may include a first printed circuit board 610, a second printed circuit board 620, a first electrical component 631, a PMIC 640, an interposer 650, a capacitor 660, and a reinforcing member 680.

Some or all of the configurations of the first printed circuit board 610, the second printed circuit board 620, the first electrical component 631, the PMIC 640, the interposer 650, and the capacitor 660 in FIG. 10 may be the same as those of the first printed circuit board 410, the second printed circuit board 420, the first electrical component 431, the PMIC 440, the interposer 450, and the capacitor 460 in FIGS. 6 to 8.

According to an embodiment, the reinforcing member 680 may be disposed adjacent to the capacitor 660. According to an embodiment, the capacitor 660 may be disposed between the reinforcing member 680 and the PMIC 640.

According to an embodiment, at least a portion of the reinforcing member 680 may be coupled to the first printed circuit board 610, and a portion different from the at least a portion may be coupled to the second printed circuit board 620.

According to an embodiment, when an external force is applied to the circuit board 600, the reinforcing member 680 may limit the proximity of the portions of the first printed circuit board 610 and the second printed circuit board 620 located adjacent to or connected to the capacitor 660. Accordingly, damage to the capacitor 660 may be prevented.

According to an embodiment, the reinforcing member 680 may be a PEM^{®} nut member, but, without being limited thereto, may be provided as various elements that prevent the capacitor 660 from being damaged by being disposed adjacent to the capacitor 660.

According to an embodiment (not illustrated), the capacitor 660 may be mounted in a recess provided in the first printed circuit board 610 or in a recess provided in the second printed circuit board 620 to secure the strength against an external force applied thereto. According to an embodiment, the recesses may be provided by removing at least some layers of the first printed circuit board 610 or the second printed circuit board 620 which includes multiple layers.

According to an embodiment (not illustrated), at least a portion of the capacitor 660 may be made of liquid metal having ductility to secure the strength against an external force applied to the capacitor 660.

According to an embodiment, the capacitor 660 may provide a conductive path P1 of power transmitted from the PMIC 640 to the first electrical component 631.

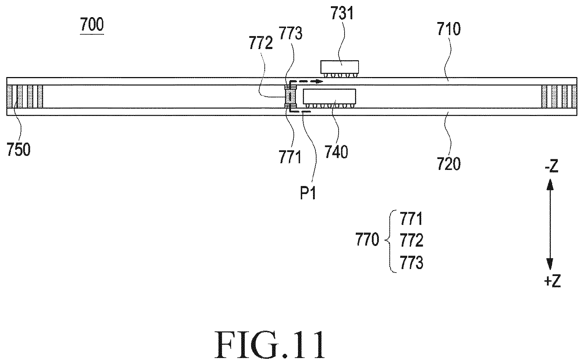

FIG. 11 is a cross-sectional view illustrating a circuit board according to an embodiment of the disclosure in a coupled state.

Referring to FIG. 11, a circuit board 700 (e.g., the circuit board 400 in FIGS. 6 to 8) may include a first printed circuit board 710, a second printed circuit board 720, a first electrical component 731, a PMIC 740, an interposer 750, and an inductor 770.

Some or all of the configurations of the first printed circuit board 710, the second printed circuit board 720, the first electrical component 731, the PMIC 740, and the interposer 750 in FIG. 10 may be the same as those of the first printed circuit board 410, the second printed circuit board 420, the first electrical component 431, the PMIC 440, and the interposer 450 in FIGS. 6 to 8.

Referring to FIG. 10, the inductor 770 may be electrically connected to one surface of the first printed circuit board 710 (e.g., the surface facing the +Z direction in FIG. 11) and one surface of the second printed circuit board 720 (e.g., the surface facing the -Z direction in FIG. 11). The inductor 770 may be disposed adjacent to the PMIC 740.

According to an embodiment, the power supplied from the PMIC 740 may be transmitted to the first electrical component 731 via a wire of the second printed circuit board 720, the inductor 770, and a wire of the first printed circuit board 710.

According to an embodiment, the inductor 770 may be defined and referred to as a power transmission member.

According to an embodiment, the inductor 770 may include a first portion 771 disposed or mounted on the second printed circuit board 771, a third portion 773 disposed or mounted on the first printed circuit board 710, and a second portion 772 interconnecting the first portion 771 and the third portion 773.

According to an embodiment, the first portion 771 may be electrically connected to a wire of the second printed circuit board 720, and the third portion 773 may be electrically connected to a wire of the first printed circuit board 710.

According to an embodiment, the second portion 772 may be defined and interpreted as a housing in which a coil of the inductor 770 is embedded.

According to an embodiment, the inductor 770 may provide a conductive path P1 of power transmitted from the PMIC 740 to the first electrical component 731.

According to an embodiment of the disclosure, an electronic device (e.g., the electronic device 101 in FIGS. 1 to 4) may include a housing (e.g., the housing 310 in FIGS. 2 to 3), a first printed circuit board (e.g., the first printed circuit board 410 in FIGS. 6 to 8), a second printed circuit board (e.g., a second printed circuit board 420 of FIGS. 6 to 8), an interposer (e.g., the interposer 450 in FIGS. 6 to 8), a first electrical component (e.g., first electrical component 431 of FIGS. 6 to 8), a power management integrated circuit, PMIC (e.g., PMIC 440 of FIGS. 6 to 8) and a capacitor (e.g., the capacitor 460 of FIGS. 6 to 8). The first printed circuit board may be disposed in the housing. The second printed circuit board may be disposed in the housing. The second printed circuit board may be spaced apart from the first printed circuit board. The interposer may be disposed along at least a portion of an edge of the first printed circuit board or at least a portion of an edge of the second printed circuit board. The interposer may be configured to support the first printed circuit board and the second printed circuit board. The interposer may be configured to transmit an electrical signal of at least one electrical component mounted on the first printed circuit board or the second printed circuit board. The first electrical component may be disposed on the first printed circuit board. The PMIC may be disposed on the second printed circuit board. The capacitor may be coupled to the first printed circuit board and the second printed circuit board. The capacitor may be spaced apart from the interposer. The capacitor may be disposed adjacent to the PMIC. The capacitor may be disposed adjacent to the first electrical component. The capacitor may be configured to supply power that is supplied from the PMIC, to the first electrical component. The capacitor may include at least two electrodes disposed to be spaced apart from and in parallel to each other.

According to an embodiment, the distance from the capacitor to the PMIC may be shorter than the distance from the capacitor to the interposer.

According to an embodiment, at least a portion of the first electrical component may be disposed to overlap at least a portion of the PMIC in a direction from the first printed circuit board toward the second printed circuit board, or in a direction from the second printed circuit board toward the first printed circuit board.

According to an embodiment, the capacitor may include a first portion (e.g., the first portion 461 in FIG. 8) and a second portion (e.g., the second portion 462 in FIG. 8). The first portion may be connected to the first printed circuit board and the second printed circuit board. The first portion may configure at least a portion of a conductive path (e.g., the conductive path P1 in FIG. 8) for power supplied from the PMIC to the first electrical component. The first portion may include a first electrode among the at least two electrodes. The second portion may be connected to the first printed circuit board and the second printed circuit board. The second portion may be connected to a ground of the second printed circuit board. The second portion may include a second electrode among the at least two electrodes.

According to an embodiment, the first printed circuit board may include a non-metal area (e.g., the non-metal area 411 in FIG. 8). The non-metal area may be provided on at least a portion of a surface facing the second printed circuit board. The non-metal area may be disposed adjacent to the first portion or the second portion of the capacitor.

According to an embodiment, the capacitor may be configured to remove a direct current component of power supplied to the first electrical component from the PMIC.

According to an embodiment, the first printed circuit board may include a copper foil layer (e.g., the copper foil layer 412 in FIG. 8). The copper foil layer may be disposed on at least a portion of the first printed circuit board.

According to an embodiment, at least a portion of the copper foil layer (e.g., the second copper foil layer 412b) may be disposed between the capacitor and the first printed circuit board.

According to an embodiment, the electronic device may further include a reinforcing member (e.g., the reinforcing member 680 in FIG. 10). The reinforcing member may be disposed adjacent to the capacitor. The reinforcing member may be coupled to the first printed circuit board and the second printed circuit board.

According to an embodiment, the capacitor may be disposed between the reinforcing member and the PMIC.

According to an embodiment, the electronic device may further include a second electrical component (e.g., the second electrical component 432 in FIGS. 6 to 8). The second electrical component may be disposed on at least a portion of the second printed circuit board.

According to an embodiment, at least a portion of the second electrical component may face at least a portion of the capacitor with the second printed circuit board interposed therebetween.

According to an embodiment, the electronic device may further include a display (e.g., the display 301 in FIG. 2). The display may be disposed in the housing. At least a portion of the second printed circuit board may be disposed between the first printed circuit board and the display.

According to an embodiment, at least a portion of the PMIC may be disposed between the capacitor and the interposer.

According to an embodiment, the capacitor may be soldered to the first printed circuit board and the second printed circuit board.

According to an embodiment of the disclosure, an electronic device (e.g., the electronic device 101 in FIGS. 1 to 4) may include a housing (e.g., the housing 310 in FIGS. 2 to 3), a battery (e.g., the battery 350 in FIG. 4), and a circuit board (e.g., the first circuit board 341 in FIG. 4 or the circuit board 400 in FIGS. 6 to 8). The battery may be disposed in the housing. The circuit board may be disposed adjacent to the battery in the housing. The circuit board may include a first printed circuit board (e.g., the first printed circuit board 410 in FIGS. 6 to 8), a second printed circuit board (e.g., the second printed circuit board 420 in FIGS. 6 to 8), an interposer (e.g., the interposer 450 in FIGS. 6 to 8), a first electrical component (e.g., the first electrical component 431 in FIGS. 6 to 8), a power management integrated circuit, PMIC (e.g., the PMIC 440 in FIGS. 6 to 8), and a capacitor (e.g., the capacitor 460 in FIGS. 6 to 8). The second printed circuit board may be spaced apart from the first printed circuit board. The interposer may be disposed along at least a portion of an edge of the first printed circuit board or at least a portion of an edge of the second printed circuit board. The interposer may be configured to support the first printed circuit board and the second printed circuit board. The interposer may be configured to transmit an electrical signal of at least one electrical component mounted on the first printed circuit board or the second printed circuit board. The first electrical component may be disposed on the first printed circuit board. The PMIC may be disposed on the second printed circuit board. The PMIC may be configured to supply power that is supplied from the battery, to the first electrical component. The capacitor may connect the first printed circuit board and the second printed circuit board. The capacitor may be disposed adjacent to the PMIC. The capacitor may be configured to supply power that is supplied from the PMIC, to the first electrical component.

According to an embodiment, the circuit board may further include a reinforcing member (e.g., the reinforcing member 680 in FIG. 10). The reinforcing member may be coupled to the first printed circuit board and the second printed circuit board. The reinforcing member may be disposed adjacent to the capacitor.

According to an embodiment, the electronic device may further include a sub-board (e.g., the second circuit board 343 in FIG. 4) and a flexible circuit board (e.g., the flexible circuit board 360 in FIG. 4). The sub-board may be disposed adjacent to the battery. The flexible circuit board may electrically interconnect at least a portion of the sub-board and at least a portion of the first printed circuit board.

According to an embodiment of the disclosure, a circuit board (e.g., the first circuit board 341 in FIG. 4 or the circuit board 400 in FIGS. 6 to 8) may include a first printed circuit board (e.g., the first circuit board 410 in FIGS. 6 to 8), a second printed circuit board (e.g., the second printed circuit board 420 in FIGS. 6 to 8), an interposer (e.g., the interposer 450 in FIGS. 6 to 8), a first electrical component (e.g., the first electrical component 431 in FIGS. 6 to 8), a power management integrated circuit, PMIC (e.g., the PMIC 440 in FIGS. 6 to 8), and a power transmission member (e.g., the capacitor 460 in FIGS. 6 to 8 or the inductor 770 in FIG. 11). The second printed circuit board may be spaced apart from the first printed circuit board. The interposer may be disposed along at least a portion of an edge of the first printed circuit board or at least a portion of an edge of the second printed circuit board. The interposer may be configured to support the first printed circuit board and the second printed circuit board. The interposer may be configured to transmit an electrical signal of at least one electrical component mounted on the first printed circuit board or the second printed circuit board. The first electrical component may be disposed on the first printed circuit board. The PMIC may be disposed on the second printed circuit board. The power transmission member may connect the first printed circuit board and the second printed circuit board. The power transmission member may be disposed adjacent to the PMIC. The power transmission member may be configured to supply power that is supplied from the PMIC, to the first electrical component.

According to an embodiment, the power transmission member may include an inductor (e.g., the inductor 770 in FIG. 11).

### [Explanation of Reference Numerals]

101: electronic device, 310: housing, 400, 500, 600, 700: circuit board, 410, 510, 610, 710: first printed circuit board, 420, 520, 620, 720: second printed circuit board, 431, 531, 631, 731: first electrical component, 440, 540, 640, 740: PMIC, 450, 550, 650, 750: interposer, 460, 560, 660, 760: capacitor

## Claims

1. An electronic device (101) comprising:
a first printed circuit board (410);
a second printed circuit board (420) spaced apart from the first printed circuit board (410);
an interposer (450) disposed along at least a portion of an edge of the first printed circuit board (410) or along at least a portion of an edge of the second printed circuit board (420), wherein the interposer (450) is configured to support the first printed circuit board (410) and the second printed circuit board (420) and to transmit an electrical signal of at least one electrical component mounted on the first printed circuit board (410) or the second printed circuit board (420), wherein the interposer (450), the first printed circuit board (410), and the second printed circuit board (420) form a stacked structure including an internal space therein;
a first electrical component (431) disposed on the first printed circuit board (410);
a power management integrated circuit, PMIC (440), disposed on the second printed circuit board (420); and
a capacitor (460) coupled to the first printed circuit board (410) and the second printed circuit board (420), and disposed adjacent to the first electrical component (431), wherein the capacitor (460) is configured to form at least a portion of a conductive path for power supplied from the PMIC (440) to the first electrical component (431), the capacitor (460) is connected to a ground of the second printed circuit board (420), and the capacitor (460) comprises at least two electrodes disposed to be spaced apart from and in parallel to each other;
wherein the capacitor (460) is spaced apart from the interposer (450);
**characterized in that** the capacitor (460) is disposed adjacent to the PMIC (440); and
**in that** the PMIC (440) and the capacitor (460) are disposed in the internal space of the stacked structure formed by the first printed circuit board (410), the second printed circuit board (420), and the interposer (450), and the PMIC (440) and the capacitor (460) are surrounded by the interposer (450).

2. The electronic device of claim 1, wherein a distance from the capacitor (460) to the PMIC (440) is shorter than a distance from the capacitor (460) to the interposer (450).

3. The electronic device of claim 1 or 2, wherein at least a portion of the first electrical component (431) is disposed to overlap at least a portion of the PMIC (440) in a direction from the first printed circuit board (410) toward the second printed circuit board (420), or in a direction from the second printed circuit board (420) toward the first printed circuit board (410).

4. The electronic device of any one of the previous claims, wherein the capacitor (460) comprises:
a first portion (461) connected to the first printed circuit board (410) and the second printed circuit board (420) and configuring the at least a portion of the conductive path (P1) for power supplied from the PMIC (440) to the first electrical component (431), wherein the first portion (461) comprises a first electrode among the at least two electrodes; and
a second portion (462) connected to the first printed circuit board (410) and the second printed circuit board (420) and connected to the ground of the second printed circuit board (420), wherein the second portion (462) comprises a second electrode among the at least two electrodes.

5. The electronic device of claim 4, wherein the first printed circuit board (410) comprises a non-metal area (411) provided on at least a portion of a surface facing the second printed circuit board (420), and
the non-metal area (411) is disposed adjacent to the first portion (461) or the second portion (462) of the capacitor (460).

6. The electronic device of claim 4 or 5, wherein the capacitor (460) is configured to remove a direct current component of power supplied to the first electrical component (431) from the PMIC (440).

7. The electronic device of any one of the previous claims, wherein the first printed circuit board (410) comprises a copper foil layer (412) disposed on at least a portion of the first printed circuit board (410).

8. The electronic device of claim 7, wherein at least a portion of the copper foil layer (412) is disposed between the capacitor (460) and the first printed circuit board (410).

9. The electronic device of any one of the previous claims, further comprising a reinforcing member (680) disposed adjacent to the capacitor (460) and coupled to the first printed circuit board (410) and the second printed circuit board (420).

10. The electronic device of claim 9, wherein the capacitor (460) is disposed between the reinforcing member (680) and the PMIC (440).

11. The electronic device of any one of the previous claims, further comprising a second electrical component (432) disposed on at least a portion of the second printed circuit board (420).

12. The electronic device of claim 11, wherein at least a portion of the second electrical component (432) faces at least a portion of the capacitor (460) with the second printed circuit board (420) interposed therebetween.

13. The electronic device of any one of the previous claims, further comprising a housing (310), wherein the first printed circuit board (410) and the second printed circuit board (420) are disposed in the housing (310), and a display (301) disposed in the housing (310),
wherein at least a portion of the second printed circuit board (420) is disposed between the first printed circuit board (410) and the display (301).

14. The electronic device of any one of the previous claims, wherein at least a portion of the PMIC (440) is disposed between the capacitor (460) and the interposer (450).

15. The electronic device of any one of the previous claims, wherein the capacitor (460) is soldered to the first printed circuit board (410) and the second printed circuit board (420).

## Patentansprüche

1. Elektronische Vorrichtung (101), die Folgendes umfasst:
eine erste Leiterplatte (410);
eine zweite Leiterplatte (420), die von der ersten Leiterplatte (410) beabstandet ist;
ein Zwischenelement (450), das zumindest entlang eines Abschnitts einer Kante der ersten Leiterplatte (410) oder entlang zumindest eines Abschnitts einer Kante der zweiten Leiterplatte (420) angeordnet ist, wobei das Zwischenelement (450) konfiguriert ist, um die erste Leiterplatte (410) und die zweite Leiterplatte (420) zu stützen und ein elektrisches Signal von mindestens einer elektrischen Komponente, die auf der ersten Leiterplatte (410) oder der zweiten Leiterplatte (420) montiert ist, zu übertragen, wobei das Zwischenelement (450), die erste Leiterplatte (410) und die zweite Leiterplatte (420) eine gestapelte Struktur bilden, die einen internen Raum darin einschließt;
eine erste elektrische Komponente (431), die auf der ersten Leiterplatte (410) angeordnet ist;
eine integrierte Leistungsmanagementschaltung (PMIC, Power Management Integrated Circuit) (440), die auf der zweiten Leiterplatte (420) angeordnet ist; und
einen Kondensator (460), der mit der ersten Leiterplatte (410) und der zweiten Leiterplatte (420) gekoppelt ist und neben der ersten elektrischen Komponente (431) angeordnet ist, wobei der Kondensator (460) konfiguriert ist, um zumindest einen Abschnitt eines leitenden Pfades für die von der PMIC (440) an die erste elektrische Komponente (431) zugeführte Leistung zu bilden, wobei der Kondensator (460) mit einer Masse der zweiten Leiterplatte (420) verbunden ist und der Kondensator (460) zumindest zwei Elektroden umfasst, die so angeordnet sind, dass sie von einander beabstandet und parallel zueinander sind;
wobei der Kondensator (460) von dem Zwischenelement (450) beabstandet ist;
**dadurch gekennzeichnet, dass** der Kondensator (460) neben der PMIC (440) angeordnet ist; und
**dadurch, dass** die PMIC (440) und der Kondensator (460) im Innenraum der durch die erste Leiterplatte (410), die zweite Leiterplatte (420) und das Zwischenelement (450) gebildeten gestapelten Struktur angeordnet sind, und die PMIC (440) und der Kondensator (460) von dem Zwischenelement (450) umgeben sind.

2. Elektronische Vorrichtung nach Anspruch 1, wobei ein Abstand von dem Kondensator (460) zu der PMIC (440) kürzer ist als ein Abstand von dem Kondensator (460) zu dem Zwischenelement (450).

3. Elektronische Vorrichtung nach Anspruch 1 oder 2, wobei zumindest ein Abschnitt der ersten elektrischen Komponente (431) so angeordnet ist, dass er zumindest einen Abschnitt des PMIC (440) in einer Richtung von der ersten Leiterplatte (410) zu der zweiten Leiterplatte (420) oder in einer Richtung von der zweiten Leiterplatte (420) zu der ersten Leiterplatte (410) überlappt.

4. Elektronische Vorrichtung nach einem der vorhergehenden Ansprüche, wobei der Kondensator (460) Folgendes umfasst:
einen ersten Abschnitt (461), der mit der ersten Leiterplatte (410) und der zweiten Leiterplatte (420) verbunden ist und den zumindest einen Abschnitt des leitenden Pfades (P1) für die Leistung konfiguriert, die von der PMIC (440) an die erste elektrische Komponente (431) zugeführt wird,
wobei der erste Abschnitt (461) eine erste Elektrode unter den zumindest zwei Elektroden umfasst; und
einen zweiten Abschnitt (462), der mit der ersten Leiterplatte (410) und der zweiten Leiterplatte (420) verbunden ist und mit der Masse der zweiten Leiterplatte (420) verbunden ist, wobei der zweite Abschnitt (462) eine zweite Elektrode unter den zumindest zwei Elektroden umfasst.

5. Elektronische Vorrichtung nach Anspruch 4, wobei die erste Leiterplatte (410) einen nichtmetallischen Bereich (411) umfasst, der zumindest auf einem Abschnitt einer Oberfläche vorgesehen ist, die auf die zweite Leiterplatte (420) gerichtet ist, und
der nicht-metallische Bereich (411) neben dem ersten Abschnitt (461) oder dem zweiten Abschnitt (462) des Kondensators (460) angeordnet ist.

6. Elektronische Vorrichtung nach Anspruch 4 oder 5, wobei der Kondensator (460) konfiguriert ist, um eine Gleichstromkomponente der von der PMIC (440) an die erste elektrische Komponente (431) zugeführte Leistung zu entfernen.

7. Elektronische Vorrichtung nach einem der vorhergehenden Ansprüche, wobei die erste Leiterplatte (410) eine Kupferfolienschicht (412) umfasst, die auf zumindest einem Abschnitt der ersten Leiterplatte (410) angeordnet ist.

8. Elektronische Vorrichtung nach Anspruch 7, wobei zumindest ein Abschnitt der Kupferfolienschicht (412) zwischen dem Kondensator (460) und der ersten Leiterplatte (410) angeordnet ist.

9. Elektronische Vorrichtung nach einem der vorhergehenden Ansprüche, die ferner ein Verstärkungselement (680) umfasst, das neben dem Kondensator (460) angeordnet und mit der ersten Leiterplatte (410) und der zweiten Leiterplatte (420) gekoppelt ist.

10. Elektronische Vorrichtung nach Anspruch 9, wobei der Kondensator (460) zwischen dem Verstärkungselement (680) und der PMIC (440) angeordnet ist.

11. Elektronische Vorrichtung nach einem der vorhergehenden Ansprüche, die ferner eine zweite elektrische Komponente (432) umfasst, die auf zumindest einem Abschnitt der zweiten Leiterplatte (420) angeordnet ist.

12. Elektronische Vorrichtung nach Anspruch 11, wobei zumindest ein Abschnitt der zweiten elektrischen Komponente (432) auf zumindest einen Abschnitt des Kondensators (460) gerichtet ist, wobei die zweite Leiterplatte (420) dazwischen angeordnet ist.

13. Elektronische Vorrichtung nach einem der vorhergehenden Ansprüche, ferner umfassend ein Gehäuse (310), wobei die erste Leiterplatte (410) und die zweite Leiterplatte (420) in dem Gehäuse (310) angeordnet sind, und eine Anzeige (301), die in dem Gehäuse (310) angeordnet ist,
wobei zumindest ein Abschnitt der zweiten Leiterplatte (420) zwischen der ersten Leiterplatte (410) und der Anzeige (301) angeordnet ist.

14. Elektronische Vorrichtung nach einem der vorhergehenden Ansprüche, wobei zumindest ein Abschnitt der PMIC (440) zwischen dem Kondensator (460) und dem Zwischenelement (450) angeordnet ist.

15. Elektronische Vorrichtung nach einem der vorhergehenden Ansprüche, wobei der Kondensator (460) mit der ersten Leiterplatte (410) und der zweiten Leiterplatte (420) verlötet ist.

## Revendications

1. Appareil électronique (101) comprenant :
une première carte de circuit imprimé (410),
une deuxième carte de circuit imprimé (420) espacée de la première carte de circuit imprimé (410),
un interposeur (450) disposé le long d'au moins une portion d'un bord de la première carte de circuit imprimé (410) ou le long d'au moins une portion d'un bord de la deuxième carte de circuit imprimé (420), ledit interposeur (450) étant conçu pour supporter la première carte de circuit imprimé (410) et la deuxième carte de circuit imprimé (420) et pour transmettre un signal électrique d'au moins un composant électrique monté sur la première carte de circuit imprimé (410) ou la deuxième carte de circuit imprimé (420), ledit interposeur (450), ladite première carte de circuit imprimé (410) et ladite deuxième carte de circuit imprimé (420) formant une structure empilée renfermant un espace interne,
un premier composant électrique (431) disposé sur la première carte de circuit imprimé (410),
un circuit intégré de gestion de l'alimentation (PMIC, power management integrated circuit) (440),
disposé sur la deuxième carte de circuit imprimé (420), et
un condensateur (460) couplé à la première carte de circuit imprimé (410) et à la deuxième carte de circuit imprimé (420), et disposé à proximité du premier composant électrique (431), ledit condensateur (460) étant conçu pour former au moins une portion d'un chemin conducteur pour l'alimentation fournie par le PMIC (440) au premier composant électrique (431), ledit condensateur (460) étant relié à la masse de la deuxième carte de circuit imprimé (420), et ledit condensateur (460) comprenant au moins deux électrodes disposées de manière à être espacées et parallèles l'une à l'autre ;
ledit condensateur (460) étant espacé de l'interposeur (450) ;
**caractérisé en ce que** le condensateur (460) est disposé adjacent au circuit intégré de gestion de l'alimentation (440), et
**en ce que** le PMIC (440) et le condensateur (460) sont disposés dans l'espace interne de la structure empilée formée par la première carte de circuit imprimé (410), la deuxième carte de circuit imprimé (420) et l'interposeur (450), et le PMIC (440) et le condensateur (460) sont entourés par l'interposeur (450).

2. Appareil électronique selon la revendication 1, dans lequel la distance entre le condensateur (460) et le PMIC (440) est plus courte que la distance entre le condensateur (460) et l'interposeur (450).

3. Appareil électronique selon la revendication 1 ou 2, dans lequel au moins une portion du premier composant électrique (431) est disposée de manière à chevaucher au moins une portion du PMIC (440) dans une direction allant de la première carte de circuit imprimé (410) vers la deuxième carte de circuit imprimé (420), ou dans une direction allant de la deuxième carte de circuit imprimé (420) vers la première carte de circuit imprimé (410).

4. Appareil électronique selon l'une quelconque des revendications précédentes, dans lequel le condensateur (460) comprend :
une première portion (461) reliée à la première carte de circuit imprimé (410) et à la deuxième carte de circuit imprimé (420) et configurant ladite au moins une portion du chemin conducteur (P1) pour l'alimentation fournie par le PMIC (440) au premier composant électrique (431), ladite première portion (461) comprenant une première électrode parmi lesdites au moins deux électrodes, et
une deuxième portion (462) reliée à la première carte de circuit imprimé (410) et à la deuxième carte de circuit imprimé (420) et reliée à la masse de la deuxième carte de circuit imprimé (420), ladite deuxième portion (462) comprenant une deuxième électrode parmi lesdites au moins deux électrodes.

5. Appareil électronique selon la revendication 4, dans lequel la première carte de circuit imprimé (410) comprend une zone non métallique (411) prévue sur au moins une portion d'une surface tournée vers la deuxième carte de circuit imprimé (420), et
la zone non métallique (411) est disposée adjacente à la première portion (461) ou la deuxième portion (462) du condensateur (460).

6. Appareil électronique selon la revendication 4 ou 5, dans lequel le condensateur (460) est conçu pour supprimer une composante de courant continu de l'alimentation fournie au premier composant électrique (431) par le PMIC (440).

7. Appareil électronique selon l'une quelconque des revendications précédentes, dans lequel la première carte de circuit imprimé (410) comprend une couche de feuille de cuivre (412) disposée sur au moins une portion de la première carte de circuit imprimé (410).

8. Appareil électronique selon la revendication 7, dans lequel l'au moins une portion de la couche de feuille de cuivre (412) est disposée entre le condensateur (460) et la première carte de circuit imprimé (410).

9. Appareil électronique selon l'une quelconque des revendications précédentes, comprenant en outre un élément de renfort (680) disposé adjacent au condensateur (460) et couplé à la première carte de circuit imprimé (410) et à la deuxième carte de circuit imprimé (420).

10. Appareil électronique selon la revendication 9, dans lequel le condensateur (460) est disposé entre l'élément de renfort (680) et le PMIC (440).

11. Appareil électronique selon l'une quelconque des revendications précédentes, comprenant en outre un deuxième composant électrique (432) disposé sur au moins une portion de la deuxième carte de circuit imprimé (420).

12. Appareil électronique selon la revendication 11, dans lequel au moins une portion du deuxième composant électrique (432) est tournée vers au moins une portion du condensateur (460), ladite deuxième carte de circuit imprimé (420) étant interposée entre celles-ci.

13. Appareil électronique selon l'une quelconque des revendications précédentes, comprenant en outre un boîtier (310), lesdites première carte de circuit imprimé (410) et deuxième carte de circuit imprimé (420) étant disposées dans le boîtier (310), et un écran (301) disposé dans le boîtier (310),
au moins une portion de la deuxième carte de circuit imprimé (420) étant disposée entre la première carte de circuit imprimé (410) et l'écran (301).

14. Appareil électronique selon l'une quelconque des revendications précédentes, dans lequel au moins une portion du PMIC (440) est disposée entre le condensateur (460) et l'interposeur (450).

15. Appareil électronique selon l'une quelconque des revendications précédentes, dans lequel le condensateur (460) est soudé à la première carte de circuit imprimé (410) et à la deuxième carte de circuit imprimé (420).
